# EUROPEAN PATENT APPLICATION

(11) **EP 4 852 678 A1**
(43) Date of publication of application: **09.12.2026**
(21) Application number: 24932016.9
(22) Date of filing: 27.03.2024
(51) Int. Cl.: H10K 59/121

(54) **DISPLAY SUBSTRATE AND DISPLAY APPARATUS**

(71) Applicant: BOE Technology Group Co., Ltd., Beijing 100015 (CN); Chengdu BOE Optoelectronics Technology Co., Ltd., Chengdu, Sichuan 611731 (CN); Beijing BOE Technology Development Co., Ltd., Beijing 100176 (CN)
(72) Inventor: ZENG, Cheng, Beijing 100176 (CN); WANG, Dan, Beijing 100176 (CN); YU, Guangri, Beijing 100176 (CN); MA, Lulin, Beijing 100176 (CN); WEI, Zhenye, Beijing 100176 (CN); WANG, Qiyun, Beijing 100176 (CN); CHENG, Xingjian, Beijing 100176 (CN); WU, Huan, Beijing 100176 (CN); HE, Yuping, Beijing 100176 (CN)
(74) Representative: Cohausz & Florack
(86) International application number: PCT/CN2024/084002
(87) International publication number: WO 2025/199785

(57) **Abstract**

The present disclosure provides a display substrate and a display device, and belongs to the technical field of display. The display substrate includes: a base substrate; pixel units arranged in an array on the base substrate, wherein each of the pixel units includes a first sub-pixel, a second sub-pixel and a third sub-pixel respectively emitting light in different colors, the first sub-pixel is in the same row as the third sub-pixel and in a different row from the second sub-pixel, wherein at least one auxiliary sub-pixel is between the second sub-pixels of the pixel units in the same row, and the at least one auxiliary sub-pixel emits light in the same color as that of the second sub-pixel.

## Description

### TECHNICAL FIELD

The present disclosure belongs to the field of display technology, and particularly, to a display substrate and a display device.

### BACKGROUND

Organic Light-Emitting diodes (OLEDs) are widely used in various display products due to their advantages such as self-luminescence, high contrast, flexibility, and foldability. The Quantum Dots (QD) material have the characteristics of continuously adjustable wavelength with a particle size, uniform light emission, pure spectrum and the like, so that the optical display effect of the product with the Quantum Dots material can be improved. The QD-OLED technology combining the Organic Light-Emitting diodes and the Quantum Dots material has advantages such as self-luminescence, high contrast, flexibility, foldability, high color gamut, excellent viewing angle and the like.

### SUMMARY

In order to solve at least one of the technical problems existing in the prior art, the present disclosure provides a display substrate and display device.

An embodiment of the present disclosure provides a display substrate, includes: a base substrate; and pixel units arranged in an array on the base substrate, wherein each of the pixel units includes a first sub-pixel, a second sub-pixel and a third sub-pixel respectively emitting light in different colors, and the first sub-pixel is in the same row as the third sub-pixel and in a different row from the second sub-pixel, wherein the display substrate includes at least one auxiliary sub-pixel between the second sub-pixels of the pixel units in the same row, wherein the at least one auxiliary sub-pixel emits light in the same color as the second sub-pixel.

The display substrate further includes a driving circuit layer on a side of a layer on which a light-emitting device is located close to the base substrate, wherein the driving circuit layer includes a first power signal line electrically coupled to a second electrode of the light-emitting device through an auxiliary electrode, and an orthographic projection of the auxiliary electrode on the base substrate is between an orthographic projection of a light-emitting device for the first sub-pixel on the base substrate and an orthographic projection of a light-emitting device for the third sub-pixel on the base substrate, with the first sub-pixel being adjacent to the third sub-pixel along a row direction .

a first interlayer insulating layer is disposed between the driving circuit layer and a layer on which a first electrode of a light-emitting device is located, and a pixel definition layer on a side of the first electrode of the light-emitting device away from the base substrate, wherein the auxiliary electrode is in the same layer as the first electrode of the light-emitting device and is coupled to the first power signal line through a first through-hole penetrating through the first interlayer insulating layer; and the pixel definition layer has a first through-hole at a position of the auxiliary electrode and penetrating through the pixel definition layer along a thickness direction of the pixel definition layer, and a side wall of the first through-hole is covered with a protective layer.

An electron conduction layer is formed on a surface of the auxiliary electrode away from the base substrate.

The first sub-pixel and the third sub-pixel belong to two different ones of the pixel units, with orthographic projections of the first sub-pixel and the third sub-pixel on the base substrate being respectively on both sides of an orthographic projection of the auxiliary electrode on the base substrate.

The display substrate further includes: a pixel definition layer on a side of a first electrode of a light-emitting device away from the base substrate, the pixel definition layer having a first accommodating portion, a second accommodating portion, a third accommodating portion, and an auxiliary accommodating portion respectively penetrating through the pixel definition layer along a thickness direction of the pixel definition layer, wherein a light-emitting layer of the light-emitting device for the first sub-pixel covers the first accommodating portion, a light-emitting layer of the light-emitting device for the second sub-pixel covers the second accommodating portion, a light-emitting layer of the light-emitting device for the third sub-pixel covers the third accommodating portion, and a light-emitting layer of the light-emitting device for the auxiliary sub-pixel covers the auxiliary accommodating portion, the second accommodating portion has a length of g1 along a row direction, a minimum distance from the first accommodating portion of the pixel unit in an i^{th} row and a j^{th} column to the auxiliary accommodating portion between the second accommodating portion of the pixel unit in the i^{th} row and the j^{th} column and the second accommodating portion of the pixel unit in the i^{th} row and a (j+1)^{th} column is l3, and a minimum distance from the first accommodating portion of the pixel unit in an (i+1)^{th} row and the j^{th} column to the auxiliary accommodating portion between the second accommodating portion of the pixel unit in the i^{th} row and the j^{th} column and the second accommodating portion of the pixel unit in the i^{th} row and the (j+1)^{th} column is l4, with i and j being positive integers, l3≥1/6×g1 and l4≤1/3×g1.

The display substrate further includes: a pixel definition layer on a side of a first electrode of a light-emitting device away from the base substrate, the pixel definition layer having a first accommodating portion, a second accommodating portion, a third accommodating portion, and an auxiliary accommodating portion respectively penetrating through the pixel definition layer along a thickness direction of the pixel definition layer, wherein a light-emitting layer of the light-emitting device for the first sub-pixel covers the first accommodating portion, a light-emitting layer of the light-emitting device for the second sub-pixel covers the second accommodating portion, a light-emitting layer of the light-emitting device for the third sub-pixel covers the third accommodating portion, and a light-emitting layer of the light-emitting device for the auxiliary sub-pixel covers the auxiliary accommodating portion, the second accommodating portion has a length of g1 along a row direction, and a plurality of auxiliary accommodating portions are disposed between the adjacent second accommodating portions, at least part of the plurality of auxiliary accommodating portions are arranged side by side along a column direction, and an interval between the auxiliary accommodating portions side by side along the column direction is l5, 1/10×g1≤l5≤1/6×g1.

The display substrate further includes: a pixel definition layer on a side of a first electrode of a light-emitting device away from the base substrate, the pixel definition layer having a first accommodating portion, a second accommodating portion, a third accommodating portion, and an auxiliary accommodating portion respectively penetrating through the pixel definition layer along a thickness direction of the pixel definition layer, wherein a light-emitting layer of the light-emitting device for the first sub-pixel covers the first accommodating portion, a light-emitting layer of the light-emitting device for the second sub-pixel covers the second accommodating portion, a light-emitting layer of the light-emitting device for the third sub-pixel covers the third accommodating portion, and a light-emitting layer of the light-emitting device for the auxiliary sub-pixel covers the auxiliary accommodating portion, the second accommodating portion has a length of g1 along a row direction, and for two second accommodating portions adjacent to each other along the row direction and the auxiliary accommodating portions between the two second accommodating portions, a minimum distance from one of the two second accommodating portions to the auxiliary accommodating portions is d1, and a minimum distance from the other of the two second accommodating portions to the auxiliary accommodating portions is d2, d1≥1/10×g1 and d2≤1/5×g1.

The display substrate further includes: a pixel definition layer on a side of a first electrode of a light-emitting device away from the base substrate, the pixel definition layer having a first accommodating portion, a second accommodating portion, a third accommodating portion, and an auxiliary accommodating portion respectively penetrating through the pixel definition layer along a thickness direction of the pixel definition layer, wherein a light-emitting layer of the light-emitting device for the first sub-pixel covers the first accommodating portion, a light-emitting layer of the light-emitting device for the second sub-pixel covers the second accommodating portion, a light-emitting layer of the light-emitting device for the third sub-pixel covers the third accommodating portion, and a light-emitting layer of the light-emitting device for the auxiliary sub-pixel covers the auxiliary accommodating portion, the second accommodating portion has a length of g1 along a row direction, and a plurality of the auxiliary accommodating portions are between the adjacent second accommodating portions, at least part of the plurality of auxiliary accommodating portions are arranged side by side along the row direction, and an interval between the auxiliary accommodating portions side by side along the row direction is d3, 1/10×g1≤d3≤1/6×g1.

Only one auxiliary sub-pixel is disposed between the second sub-pixels adjacent to each other along a row direction, and a ratio of an aperture ratio of the auxiliary sub-pixel to an aperture ratio of each second sub-pixel ranges from 0.5 to 10.

A plurality of auxiliary sub-pixels are arranged side by side along a row direction between the second sub-pixels adjacent to each other along the row direction, and a ratio of an aperture ratio of each auxiliary sub-pixel to an aperture ratio of each second sub-pixel ranges from 0.1 to 0.6.

A plurality of the auxiliary sub-pixels are arranged side by side along a column direction between the second sub-pixels adjacent to each other along a row direction, and a ratio of an aperture ratio of each auxiliary sub-pixel to an aperture ratio of each second sub-pixel ranges from 0.1 to 0.6.

A plurality of auxiliary sub-pixels are disposed between the second sub-pixels adjacent to each other along a row direction, a part of the plurality of auxiliary sub-pixels are disposed side by side along the row direction, the other part of the plurality of auxiliary sub-pixels are disposed side by side along a column direction, and a ratio of an aperture ratio of each auxiliary sub-pixel to an aperture ratio of each second sub-pixel ranges from 0.05 to 0.4.

A plurality of auxiliary sub-pixels are disposed between the second sub-pixels adjacent to each other along a row direction, and aperture ratios of at least part of the plurality of auxiliary sub-pixels are different from each other.

For the plurality of auxiliary sub-pixels between the second sub-pixels adjacent to each other along the row direction, a ratio of an aperture ratio of the auxiliary sub-pixel with the largest aperture ratio to an aperture ratio of the auxiliary sub-pixel with the smallest aperture ratio ranges from 1.5 to 4.

The first sub-pixel, the second sub-pixel, the third sub-pixel, and the auxiliary sub-pixel each include a light-emitting device emitting light in a third color, and the first sub-pixel further includes a first quantum dot unit on a light outgoing side of the light-emitting device, the second sub-pixel further includes a second quantum dot unit on the light outgoing side of the light-emitting device, and the auxiliary sub-pixel further includes an auxiliary quantum dot unit on the light outgoing side of the light-emitting device, with the first quantum dot unit being configured to emit light in a first color under excitation of light in the third color and the second quantum dot unit and the auxiliary quantum dot unit being both configured to emit light in a second color under excitation of light in the third color.

A material of the auxiliary quantum dot unit is different from a material of the second quantum dot unit.

The quantum dots in the materials of the auxiliary quantum dot unit and the second quantum dot unit are the same in type and different in distribution density; and/or the quantum dots in the materials of the auxiliary quantum dot unit and the second quantum dot unit are the same in type and different in particle size.

A type of quantum dots in the material of the auxiliary quantum dot unit is different from that of quantum dots in the material of the second auxiliary quantum dot unit.

An embodiment of the present disclosure provides a display device including the display substrate described above.

### BRIEF DESCRIPTION OF DRAWINGS

FIG. 1 is a top view of an exemplary display substrate.
FIG. 2 is a cross-sectional view of an exemplary display substrate.
FIG. 3 is a top view of a display substrate in a first example according to an embodiment of the present disclosure.
FIG. 4 is a cross-sectional view of a display substrate according to an embodiment of the present disclosure.
FIG. 5 is a flowchart showing a process for forming auxiliary electrodes by forming holes in a display substrate according to an embodiment of the present disclosure.
FIG. 6 is a partial enlarged view showing a position of an auxiliary electrode of a display substrate according to an embodiment of the present disclosure.
FIG. 7a is a schematic cross-sectional view showing a portion of a display substrate in a first example according to an embodiment of the present disclosure.
FIG. 7b is a schematic cross-sectional view showing a portion of a display substrate in a first example according to an embodiment of the present disclosure.
FIG. 8a is a spectrum diagram of different quantum dot material systems.
FIG. 8b is an absorption diagram for different quantum dot material systems.
FIG. 9 is a top view of a display substrate in a second example according to an embodiment of the present disclosure.
FIG. 10 is a top view of a display substrate in a third example according to an embodiment of the present disclosure.
FIG. 11 is a top view of a display substrate in a fourth example according to an embodiment of the present disclosure.
FIG. 12 is a top view of a display substrate in a fifth example according to an embodiment of the present disclosure.
FIG. 13 is a top view of a display substrate in a sixth example according to an embodiment of the present disclosure.
FIG. 14 is a top view of a display substrate in a seventh example according to an embodiment of the present disclosure.
FIG. 15 is a top view of a display substrate in an eighth example according to an embodiment of the present disclosure.

### DETAIL DESCRIPTION OF EMBODIMENTS

In order to enable one of ordinary skill in the art to better understand the technical solutions of the present disclosure, the present disclosure will be described in further detail with reference to the accompanying drawings and the detailed description.

Unless defined otherwise, technical or scientific terms used herein shall have the ordinary meaning as understood by one of ordinary skill in the art to which the present disclosure belongs. The terms "first", "second", and the like used in the present disclosure are not intended to indicate any order, quantity, or importance, but rather are used for distinguishing one element from another. Further, the term "a", "an", "the", or the like used herein does not denote a limitation of quantity, but rather denotes the presence of at least one element. The term of "comprising", "including", or the like, means that the element or item preceding the term contains the element or item listed after the term and its equivalent, but does not exclude other elements or items. The term "connected", "coupled", or the like is not limited to physical or mechanical connections, but may include electrical connections, whether direct or indirect connections. The terms "upper", "lower", "left", "right", and the like are used only for indicating relative positional relationships, and when the absolute position of an object being described is changed, the relative positional relationships may also be changed accordingly.

Before the embodiments of the present disclosure are described, it should be noted that the embodiments of the present disclosure will be illustrated by only taking the followings as an example: a first sub-pixel is a red sub-pixel, a second sub-pixel is a green sub-pixel, and a third sub-pixel is a blue sub-pixel. Accordingly, the light in a first color emitted by the first sub-pixel is red light, the light in a second color emitted by the second sub-pixel is green light, and the light in a third color emitted by the third sub-pixel is blue light. An auxiliary sub-pixel emits light in the same color as the light emitted by the second sub-pixel, that is, the light emitted by the auxiliary sub-pixel is green light. Accordingly, a first quantum dot unit is a red quantum dot unit, and a second quantum dot unit is a green quantum dot unit; the red quantum dot unit may emit red light under the excitation of blue light, and the green quantum dot unit and an auxiliary quantum dot unit may emit green light under the excitation of blue light. A first electrode of a light-emitting device being an anode and a second electrode being a cathode will be taken as an example in the embodiments of the present disclosure.

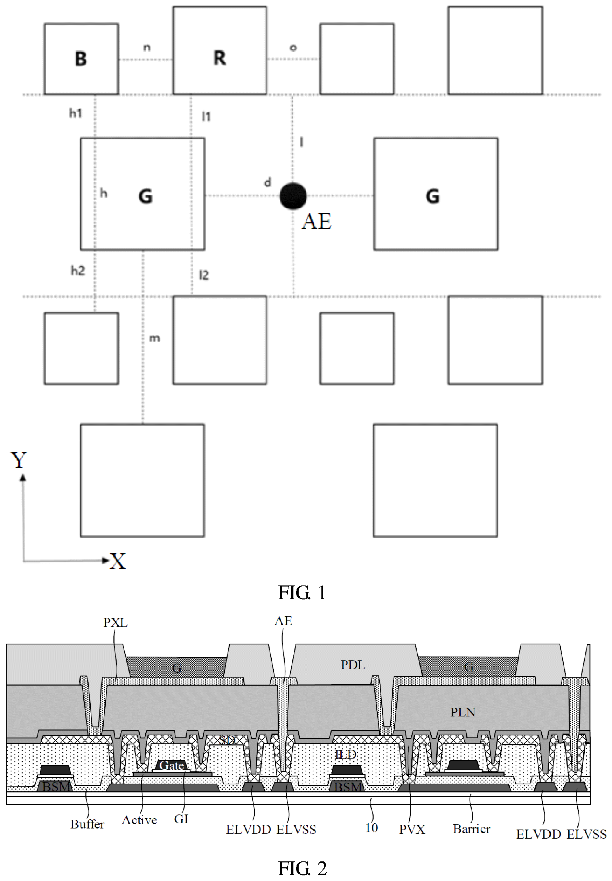

FIG. 1 is a top view of an exemplary display substrate. As shown in FIG. 1, the display substrate includes a base substrate 10 and pixel units 100 arranged in an array on the base substrate 10. Each of the pixel units 100 includes three sub-pixels, that is, a red sub-pixel R, a green sub-pixel G, and a blue sub-pixel B. The red sub-pixel R and the blue sub-pixel B in each pixel unit 100 are located in the same row, and are located in a different row from the green sub-pixel G.

Specifically, the display substrate at least includes a driving circuit layer and a light-emitting device layer sequentially disposed on the base substrate 10. The driving circuit layer includes pixel driving circuits for the sub-pixels and signal lines electrically coupled to the pixel driving circuits respectively. The light-emitting device layer includes light-emitting devices for the sub-pixels. Each pixel driving circuit includes electrical elements such as a thin film transistor and a storage capacitor. Each light-emitting device may be an OLED, and an anode of the light-emitting device is electrically coupled to the pixel driving circuit. Furthermore, the display substrate may further include a quantum dot layer on a light-emitting surface side or a light outgoing side of the light-emitting device. The quantum dot layer includes a red quantum dot unit in the red sub-pixel R and a green quantum dot unit in the green sub-pixel G. When the display substrate includes the quantum dot layer, each of the light-emitting devices is a blue light-emitting device that emits blue light.

The structures of the layers in the display substrate will be illustrated in detail below. FIG. 2 is a cross-sectional view of an exemplary display substrate. As shown in FIG. 2, the display substrate includes, in order from bottom to top: a base substrate 10 made of polyimide with a thickness ranging from 1um to 5um; a barrier layer made of SiO₂ with a thickness ranging from 100nm to 800nm; a light shielding layer (also known as back shield mask, BSM) made of a metal material such as chromium, nickel, manganese, molybdenum, vanadium, manganese, etc., with a thickness ranging from 200nm to 1000nm; a layer, where a first power signal line ELVSS and a second power signal line ELVDD are located, made of metal materials such as aluminum, copper, tungsten, titanium, molybdenum, gold, etc., with a thickness ranging from 100nm to 600nm; a buffer layer made of SiOx, SiNOx, SiNx or the like with a thickness ranging from 200nm to 800nm; an active layer of the thin film transistor made of metal oxide, amorphous silicon, polycrystalline silicon or the like; a gate insulating layer (GIL) or a gate insulator made of SiOx, SiNOx, SiNx or the like with a thickness ranging from 100nm to 400nm; a gate metal layer, at least including a gate electrode (Gate) of the thin film transistor and a gate line, made of copper, molybdenum, tungsten, titanium or the like with a thickness ranging from 200nm to 1000nm; an interlayer dielectric layer made of SiNOx, SiNx, or the like with a thickness ranging from 500nm to 2000nm; a source-drain electrode (SD) layer, at least including a source electrode and a drain electrode of the thin film transistor, a data line and the like, made of copper, molybdenum, tungsten, titanium or the like with a thickness ranging from 100nm to 400nm; a passivation layer (PVX) layer made of SiOx, SiNOx, SiNx or the like with a thickness ranging from 200nm to 600nm; a planarization Layer (PLN) made of polyimide with a thickness ranging from 1um to 5um; an anode layer (Anode) of the light-emitting device made of a metal, such as Ag, Mg, Al, Pt, Au, Ni, Nd, or the like or a metal oxide such as ITO, IGO, ITZO, IGZO or the like with a thickness ranging from 100nm to 200nm; a pixel definition layer (PDL) made of polyimide with a thickness ranging from 1um to 3um. Of course, a light-emitting layer, a cathode layer, and the like of the light-emitting device are also disposed on the pixel definition layer, and are not shown in the drawings. Further, in order to reduce a resistance of the cathode of the light-emitting device, a via hole penetrating through the interlayer insulating layer, the passivation layer, the planarization layer, and the pixel definition layer is formed between the two green sub-pixels G by means including, but not limited to, laser drilling, so that the cathode of the light-emitting device is electrically coupled to the first power signal line ELVSS through an auxiliary electrode AE disposed in the same layer as the anode of the light-emitting device. In this way, the resistivity of the layers can be effectively decreased, the surface resistance and the current can be decreased, and the uniformity of the product can be improved. It should be noted that the auxiliary electrode AE may be electrically coupled to the first power signal line ELVSS through a connection electrode located in the source-drain (SD) electrode layer.

In addition, it should be noted that the pixel definition layer includes a first accommodating portion, a second accommodating portion, and a third accommodating portion penetrating through the pixel definition layer along a thickness direction of the pixel definition layer. The light-emitting layer of the light-emitting device for the red sub-pixel R covers at least the first accommodating portion, the light-emitting layer of the light-emitting device for the green sub-pixel G covers at least the second accommodating portion, and the light-emitting layer of the light-emitting device for the blue sub-pixel B covers at least the third accommodating portion. Aperture sizes of the first, second, and third accommodating portions define aperture ratios of the red, green, and blue sub-pixels R, G, and B, respectively. In the embodiment of the present disclosure, a distance between the accommodating portions refers to a distance between orthographic projections of the accommodating portions on the base substrate 10. A distance between the sub-pixels also refers to the distance between the orthographic projections of the accommodating portions on the base substrate 10.

With continued reference to FIG. 1, the blue sub-pixels B and the red sub-pixels R in each row of pixel units 100 are alternately arranged side by side along a row direction X. A distance between the blue sub-pixel B and the red sub-pixel R in each pixel unit 100 is n. A distance from the red sub-pixel R in each pixel unit 100 to the blue sub-pixel B in the pixel unit 100 in the same row and adjacent to the red sub-pixel R is o. A distance between two blue sub-pixels B in the pixel units 100 in the same column and adjacent to each other is h. A distance between two red sub-pixels R in the pixel units 100 in the same column and adjacent to each other is l. Ends, away from the corresponding red sub-pixel R, of the green sub-pixels G in the pixel units 100 in the same row are located on the same horizontal line, and a distance between the adjacent green sub-pixels G is d. A distance between the green sub-pixels G in the pixel units 100 in the same column is m. Minimum distances from each green sub-pixel G respectively to the blue sub-pixel B and the red sub-pixel R in the same pixel unit 100 as the green sub-pixel G are h1 and l1. Minimum distances from each green sub-pixel G respectively to the blue sub-pixel B and the red sub-pixel R in the pixel unit 100 which are in the same column as and adjacent to the green sub-pixel G are h2 and l2. Each of the red sub-pixel R, the green sub-pixel G, and the blue sub-pixel B has a shape of quadrangle, that is, each of the openings of the accommodating portions has a shape of quadrangle. A ratio for the aperture ratios of the green sub-pixel G, the red sub-pixel R, and the blue sub-pixel B is x1 which satisfies 1.6:1.4:1≤x1≤1.8:1.2:1. If lengths along a row direction X and widths along a column direction Y, of the green sub-pixel G, the red sub-pixel R, and the blue sub-pixel B are g1, g2, r1, r2, b1, and b2, respectively, wherein 50nm≤g1, g2≤200nm, 50nm≤r1, r2≤150nm, 20nm≤ b1, b2≤100nm. The size of each sub-pixel satisfies the followings: 50nm≤g1, g2 ≤200nm, 50nm≤r1, r2≤150nm, 20nm≤b1, b2≤100nm. The distances between the sub-pixels meets the followings: 1/4×b1≤n, o≤r1, with n and o being equal to each other or different from each other; 1/2×g1≤d≤5/2×g1, 2×r1≤l≤4×r1, 3×b1 ≤h≤6×b1, g1≤m≤2×g1, 1/10×g1≤h1, l1≤1/3×g1, with h1 and l1 being equal to each other or different from each other; 1/10×g1≤h2, l2≤1/2×g1, with h2 and l2 being equal to each other or different from each other. The auxiliary electrode AE is located in the middle of the two green sub-pixels G, i.e., a distance between the auxiliary electrode AE and the red sub-pixel R or the blue sub-pixel B is l/2 and a distance between the auxiliary electrode AE and the green sub-pixel G is d/2.

On the basis of the above display substrate, in order to optimize the performance of the display substrate, at least one auxiliary sub-pixel is disposed between adjacent green sub-pixels. The auxiliary sub-pixel is configured to emit green light. The performance of the display substrate can be improved by arranging the auxiliary sub-pixel emitting green light and by controlling the auxiliary sub-pixel to emit light. For example, the overall brightness and the efficiency of the device can be improved by controlling the auxiliary sub-pixel and the green sub-pixel to emit light simultaneously. In order to reduce the power consumption of the product, the auxiliary sub-pixel may be controlled to emit light after the green light-emitting device emits light for a certain time. For example, the auxiliary sub-pixel may be controlled to emit light after the brightness of the green sub-pixel decreases to 80% of the initial value, so as to increase the lifetime of the product.

In some examples, one or more auxiliary sub-pixels may be disposed between the green sub-pixels. In a case where a plurality of auxiliary sub-pixels are disposed between the green sub-pixels, the plurality of auxiliary sub-pixels are arranged side by side along the row direction X or the column direction Y, or may include auxiliary sub-pixels arranged side by side along the row direction X and auxiliary sub-pixels arranged side by side along the column direction Y.

When the display substrate includes one or more auxiliary sub-pixels, the pixel definition layer of the display substrate is provided with an auxiliary accommodating portion for accommodating a light-emitting layer of the light-emitting device of the auxiliary sub-pixel. The second accommodating portion has a length of g1 along the row direction X. A minimum distance from the first accommodating portion of the pixel unit in the i^{th} row and j^{th} column to the auxiliary accommodating portions is l3, with the auxiliary accommodating portions being located between the second accommodating portion of the pixel unit in the i^{th} row and j^{t}h column and the second accommodating portion of the pixel unit in the i^{th} row and (j+1)^{th} column. A minimum distance from the first accommodating portion of the pixel unit in the (i+1)^{th} row and the jth column to the auxiliary accommodating portions is l4, with the auxiliary accommodating portions being located between the second accommodating portion of the pixel unit in the i^{th} row and the j^{th} column and the second accommodating portion of the pixel unit in the i^{th} row and the (j+1)^{th} column, wherein i and j are positive integers, l3≥1/6×g1 and l4 ≤ 1/3 × g1. Furthermore, in a case where the plurality of auxiliary accommodating portions are disposed between the adjacent second accommodating portions, at least part of the auxiliary accommodating portions are arranged side by side along the column direction Y, and an interval between the auxiliary accommodating portions arranged side by side along the column direction Y is l5, 1/10×g1≤l5≤1/6×g1.

For two second accommodating portions adjacent to each other along the row direction X and the auxiliary accommodating portions between the two second accommodating portions, a minimum distance from one of the two second accommodating portions to the auxiliary accommodating portions is d1, and a minimum distance from the other of the two second accommodating portions to the auxiliary accommodating portions is d2, d1 ≥ 1/10 × g1 and d2 ≤ 1/5 × g1. Furthermore, a plurality of auxiliary accommodating portions may be arranged between the adjacent second accommodating portions, at least part of the plurality of auxiliary accommodating portions are arranged side by side along the row direction X, and an interval between the auxiliary accommodating portions arranged side by side along the row direction X is d3, 1/10×g1≤d3≤1/6×g1.

The present disclosure will be described below in combination with specific examples.

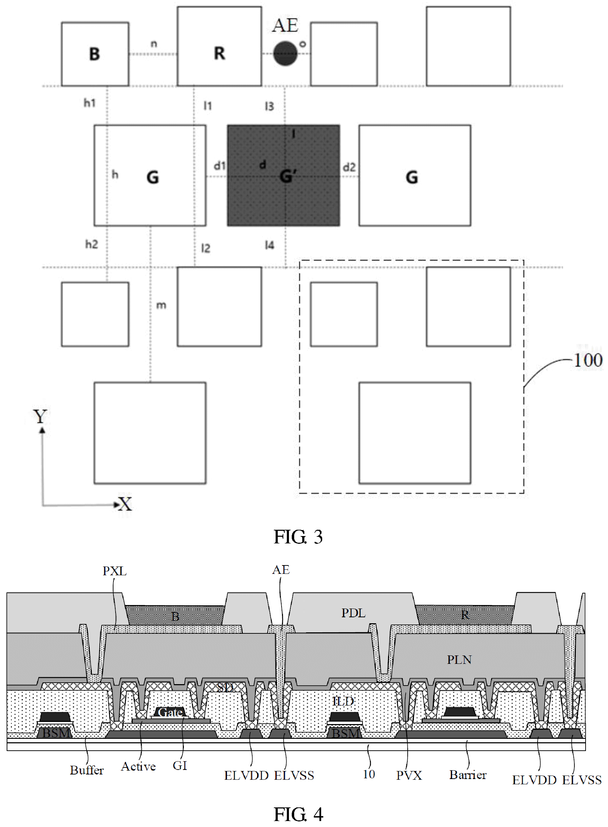

In the first example, FIG. 3 is a top view of a display substrate in a first example according to an embodiment of the present disclosure. As shown in FIG. 3, in the example, only one auxiliary sub-pixel G' is disposed between green sub-pixels G adjacent to each other along the row direction X. A shape of the opening of the auxiliary accommodating portion of the auxiliary sub-pixel G' is the same as that of the second accommodating portion of the green sub-pixel G, that is, a quadrangle. A ratio of the aperture ratio of the green sub-pixel G to the aperture ratio of the auxiliary sub-pixel G' ranges from 0.5 to 1.0. The green sub-pixel G has a length of g1 along the row direction X, for example, g1≧50 nm.

The minimum distance from the first accommodating portion of the pixel unit 100 in the i^{th} row and j^{th} column to the auxiliary accommodating portions is l3, with the auxiliary accommodating portions located between the second accommodating portion of the pixel unit 100 in the i^{th} row and j^{th} column and the second accommodating portion of the pixel unit 100 in the i^{th} row and (j+1)^{th} column. The minimum distance from the first accommodating portion of the pixel unit 100 in the (i+1)^{th} row and the j^{th} column to the auxiliary accommodating portions is l4, with the auxiliary accommodating portions located between the second accommodating portion of the pixel unit 100 in the i^{th} row and the j^{th} column and the second accommodating portion of the pixel unit 100 in the i^{th} row and the (j+1)^{th} column. That is, in FIG. 3, a distance from a top edge of the auxiliary sub-pixel G' and a bottom edge of the red sub-pixel R nearest or closest to the top edge of the auxiliary sub-pixel G' is l3, and a distance from a bottom edge of the auxiliary sub-pixel G' to a top edge of the red sub-pixel R nearest the bottom edge of the auxiliary sub-pixel G' is l4. For example, 1/6×g1≤l3 and l4≤1/3×g1, wherein l3 and l4 may be equal to each other or different from each other.

The distances from the auxiliary sub-pixel G' to the two green sub-pixels G on two opposite sides of the auxiliary sub-pixel G are d1 and d2 respectively, with d1 and d2 being equal to or different from each other, 1/10×g1 ≤d1 and d2≤1/5×g1.

In this example, the auxiliary sub-pixel G' and the green sub-pixel G are controlled to emit light simultaneously, thereby improving the overall brightness and efficiency of the device. In order to reduce the power consumption of the product, the auxiliary sub-pixel G' may be controlled to emit light after the green light-emitting device emits light for a certain time. For example, the auxiliary sub-pixel G' may be controlled to emit light after the brightness of the green sub-pixel G decays to 80% of the initial value, so as to increase the lifetime of the product. In addition, in a dark environment (e.g., below 64 gray levels), the auxiliary sub-pixel G' may be independently lightened, so that the contrast of the product can be improved, and the power consumption of the product can be reduced.

The sizes of the red, green and blue sub-pixels R, G and B and intervals between the red, green and blue sub-pixels R, G and B in the example may be the same as those in FIG. 1, and thus will not be described herein.

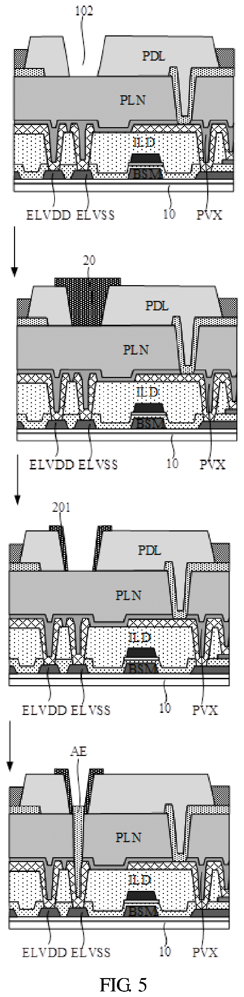

In some examples, FIG. 4 is a cross-sectional view of a display substrate according to an embodiment of the present disclosure. As shown in FIG. 4, a difference between the examples in FIGS. 4 and 1 is that the auxiliary electrode AE needs to be disposed between the red sub-pixel R and the blue sub-pixel B in the example, the auxiliary sub-pixel G' is disposed between the adjacent green sub-pixels G in FIG. 1. The auxiliary electrode AE may also be disposed in the same layer as the anode of the light-emitting device, and in this case, the auxiliary electrode AE needs to be coupled to the first power signal line through a first via-hole penetrating through a first interlayer insulating layer (including the gate insulating layer, the interlayer insulating layer, the passivation layer, and the planarization layer disposed in sequence along a direction away from the base substrate 10). In order to electrically couple the auxiliary electrode AE to the cathode of the light-emitting device, a portion of the pixel definition layer at the position corresponding to the auxiliary electrode AE needs to be etched to form a second via-hole. Since the distance from the first accommodating portion of the red sub-pixel R to the third accommodating portion of the blue sub-pixel B is small, after the first via-hole of the auxiliary electrode AE is formed therein, a current may leak laterally when the light-emitting device of the blue sub-pixel B and the light-emitting device of the red sub-pixel R are in normal operation, which may cause a crosstalk phenomenon, and thus, the structure at the via-hole is required to be optimized. Preferably, FIG. 5 is a flowchart showing a process for forming auxiliary electrodes AE by forming holes in a display substrate according to an embodiment of the present disclosure. As shown in FIG. 5, the auxiliary electrode AE is formed by forming a hole in the pixel definition layer through a photolithography or laser technology; filling the hole with a material 20 with a low dielectric constant including an inorganic material such as SiOx, SiNOx, SiNx, porous silicon dioxide, etc., and/or an organic material such as polyimide, polynorbornene, benzocyclobutene, PTFE, etc; forming a first via-hole and a second via-hole 102 through the photolithography or laser technology, wherein a protective layer 21 made of the material with a low dielectric constant is formed on a side wall of the second via-hole 102; and finally forming the auxiliary electrode AE in the hole, wherein the auxiliary electrode AE is made of aluminum, copper, tungsten, titanium, molybdenum, gold or the like.

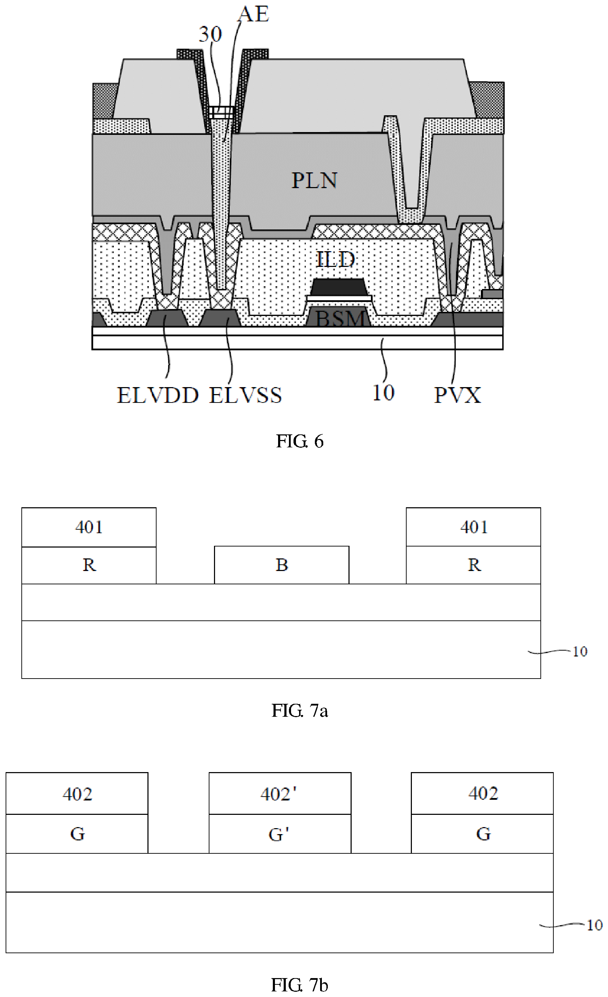

FIG. 6 is a partial enlarged view showing a position of an auxiliary electrode AE of a display substrate according to an embodiment of the present disclosure. As shown in FIG. 6, in order to further reduce the resistance, an electron conduction layer 30 is formed on a surface of the auxiliary electrode AE away from the base substrate 10, and a material of the electron conduction layer includes a metal oxide layer, such as ITO, IGO, ITZO, IGZO, or the like, and the electron conduction layer may increase the conductivity of electrons, so as to decrease the resistivity ρ of the film layer, further decrease the current drop of the product, and improve the uniformity of the product. In this case, the number of the auxiliary electrodes AE may be reduced. Preferably, the auxiliary electrode AE is formed only between the red and blue sub-pixels R and B respectively belonging to different pixel units 100. That is, the orthographic projections of the auxiliary electrodes AE on the base substrate 10 are located between the orthographic projections, on the base substrate 10, of the first accommodating portion and the third accommodating portion respectively belonging to the two different pixel units 100.

In some examples, FIG. 7a is a schematic cross-sectional view showing a portion of a display substrate in a first example according to an embodiment of the present disclosure. FIG. 7b is a schematic cross-sectional view showing a portion of a display substrate in a first example according to an embodiment of the present disclosure. As shown in FIG. 7a and FIG. 7b, the light-emitting device of each sub-pixel emits blue light. A red quantum dot unit 401 is formed on a light outgoing side of the light-emitting device of the red sub-pixel R, a green quantum dot unit 402 is formed on a light outgoing side of the light-emitting device of the green sub-pixel G, and an auxiliary quantum dot unit 402' is formed on a light outgoing side of the light-emitting device of the auxiliary sub-pixel G'.

In some examples, the quantum dots in the material of the auxiliary quantum dot unit 402' and the quantum dots in the material of the green quantum dot unit 402 are different from each other. It should be noted that in the embodiments of the present disclosure, the materials of the quantum dot units are considered to be different from each other if one of the followings is satisfied: quantum dots in the materials of the quantum dot units have different types; the types of quantum dots in the materials of the quantum dot units are the same, and distribution densities of the quantum dots are different from each other; and the types of the quantum dots in the material of the quantum dot unit are the same but particle sizes of the quantum dots are different from each other and the like.

In one example, the quantum dot material of the auxiliary quantum dot unit 402' may include Cd or perovskite (Pb) system material, and the quantum dot materials of the red quantum dot unit 401 and the green quantum dot unit 402 may include InP, so that the color gamut and efficiency of the light-emitting devices may be improved. Of course, the quantum dot materials of the auxiliary quantum dot unit 402' and the green quantum dot unit 402 may have the same type, for example, Cd or perovskite (Pb) system materials, as long as the particle sizes and/or densities of the quantum dots of the materials of the auxiliary quantum dot unit 402' and the green quantum dot unit 402 are different from each other.

The comparison between the optical properties of the different material systems is given in Table 1 below.

**Table 1:**

| Material System | Material FWHM (full width at half maximum)/nm | | BT202 color gamut @CIE1931 | Conversion Rate/% (Conversion Rate for InP is 100%) | |
|---|---|---|---|---|---|
| | R | G | | R | G |
| InP | 35 | 40 | 85 | 100 | 100 |
| Cd | 20 | 20 | > 95 | 200 | 150 |
| Perovskite (Pb) | 25 | 20 | > 95 | 170 | 140 |
| InP+Cd | 25 | 25 | > 90 | 120~140 | 110~120 |
| InP+ Perovskite | 30 | 25 | > 90 | 110~130 | 110~120 |

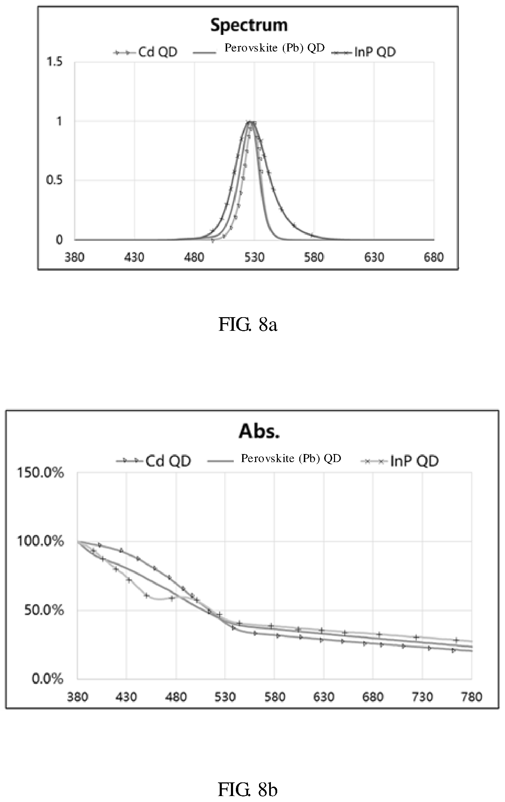

The aperture ratio of the auxiliary sub-pixel G' is set to be in a range from 5% to 10%. In order to satisfy the requirement of RoHS (Restriction of Hazardous Substances) for heavy metals, when the quantum dot ink employed by the auxiliary quantum dot unit 402' of the auxiliary sub-pixel G' includes Cd quantum dots, the content of the Cd quantum dots therein may be set as: 1000ppm ≤ x ≤ 2000ppm. When the quantum dot ink employed by the auxiliary quantum dot unit 402' of the auxiliary sub-pixel G' includes perovskite, the content of Pb in the perovskite quantum dot may be set as: 10000ppm ≤ x ≤ 20000ppm, the remaining part may be filled with InP material, and the concentration (i.e., solid content) of InP material ranges from 20% to 40%. FIG. 8a is a spectrum diagram for different quantum dot material systems. It can be seen from FIG. 7 that the FWHMs of the quantum dots for Cd and perovskite (Pb) systems are narrower than that of InP system, so the color purities for Cd and perovskite (Pb) systems are purer under the same Peak condition. FIG. 8b is an absorption diagram for different quantum dot material systems. It can be seen from FIG. 8 that in the blue light band from 430nm to 480nm, the absorption rates of different QD material systems are: Cd > perovskite (Pb) > InP, so that the conversion rates of the QD material systems also follow the above rules.

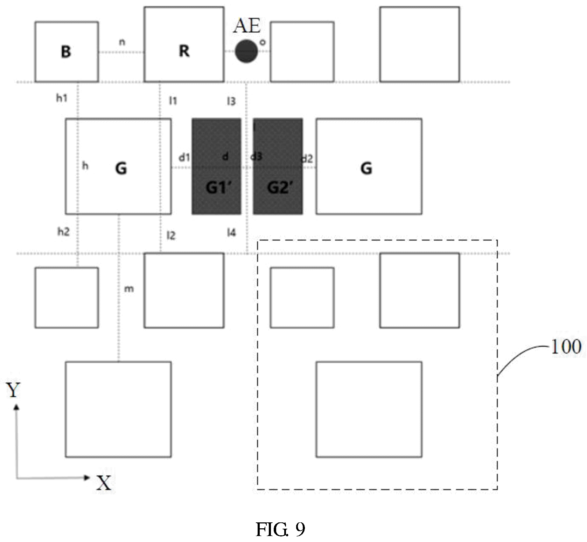

As a second example, FIG. 9 is a top view of a display substrate in the second example according to an embodiment of the present disclosure. As shown in FIG. 9, the second example is different from the first example in that two auxiliary sub-pixels G' (i.e., a first auxiliary sub-pixel G1' and a second auxiliary sub-pixel G2') are disposed between two green sub-pixels G adjacent to each other along the row direction X, and the first auxiliary sub-pixel G1' and the second auxiliary sub-pixel G2' are arranged side by side along the row direction X. The first auxiliary sub-pixel G1' and the second auxiliary sub-pixel G2' have the same size, and a ratio of an aperture ratio of each of the first auxiliary sub-pixel G1' and the second auxiliary sub-pixel G2' to an aperture ratio of the green sub-pixel G ranges from 0.1 to 0.4.

In some examples, since the first and second auxiliary sub-pixels G1' and G2' have the same size, a distance from a top edge of the first auxiliary sub-pixel G1' to the bottom edge of the red sub-pixel R nearest the top edge of the first auxiliary sub-pixel G1' is l3, and a distance from a top edge of the second auxiliary sub-pixel G2' to the bottom edge of the red sub-pixel R nearest the top edge of the second auxiliary sub-pixel G2' is also l3. A distance from a bottom edge of the first auxiliary sub-pixel G1' to the top edge of the red sub-pixel R closest to the bottom edge of the first auxiliary sub-pixel G1' is l4, and a distance from a bottom edge of the second auxiliary sub-pixel G2' to the top edge of the red sub-pixel R closest to the bottom edge of the second auxiliary sub-pixel G2' is l4. For example, 1/6×g1 ≤ l3, and l4≤1/3×g1, wherein l3 and l4 may be equal to or different from each other.

A distance from the first auxiliary sub-pixel G1' to the green sub-pixel G nearest the first auxiliary sub-pixel G1' is d1, and a distance from the second auxiliary sub-pixel G2' to the green sub-pixel G nearest the second auxiliary sub-pixel G2' is d2, and d1 and d2 may be equal to or different from each other. 1/10×g1 ≤ d1, and d2≤1/5×g1.

A distance from the first auxiliary sub-pixel G1' to the second auxiliary sub-pixel G2' is d3, wherein 1/10×g1≤d3≤1/6×g1.

In some examples, the aperture ratios of the first auxiliary sub-pixel G1' and the second auxiliary sub-pixel G2' may be different from each other. For example, a ratio of the aperture ratio of the first auxiliary sub-pixel G1' to the aperture ratio of the second auxiliary sub-pixel G2' is in a range from about 1.5 to 4. At this time, one of the first auxiliary sub-pixel G1' and the second auxiliary sub-pixel G2' may be selected to be lighted up according to the requirement, so that the power consumption can be reduced.

In this example, the first auxiliary sub-pixel G1' includes a first auxiliary quantum dot unit located on a light outgoing side of the light-emitting device, and the second auxiliary sub-pixel G2' includes a second auxiliary quantum dot unit located on a light outgoing side of the light-emitting device. The quantum dot materials in the first auxiliary quantum dot unit and the second auxiliary quantum dot unit may include Cd or perovskite (Pb) system materials. The quantum dot materials in the first auxiliary quantum dot unit and the second auxiliary quantum dot unit may be the same as or different from each other. The quantum dot materials in the red quantum dot unit 401 and the green quantum dot unit 402 may include InP, so as to improve the color gamut and efficiency of the light-emitting device.

The aperture ratios of the first and second auxiliary sub-pixels G1' and G2' are set to be in a range from 2% to 5%, the aperture ratios of the first and second auxiliary sub-pixels G1' are the same. In order to meet the requirement of RoHS on heavy metals, when the materials (i.e., the quantum dot ink) of the first auxiliary quantum dot unit and the second auxiliary quantum dot unit include Cd quantum dots, the content of the Cd quantum dots may be set as follows: 1000ppm ≤ x ≤ 2500ppm. When the materials (i.e., the quantum dot ink) of the first auxiliary quantum dot unit and the second auxiliary quantum dot unit include perovskite, the content of Pb in the perovskite quantum dot may be set as follows: 10000ppm ≤ x ≤ 25000ppm, and the remaining part may be filled with InP material, and a concentration (i.e., solid content) of the InP material may be set to be in a range from 20% to 40%.

In this example, in addition to the same effect as in the first example, since the two auxiliary sub-pixels G' are disposed between the two green sub-pixels G, one or two of the two auxiliary sub-pixels G' may also be selected to be lighted up to improve the device performance.

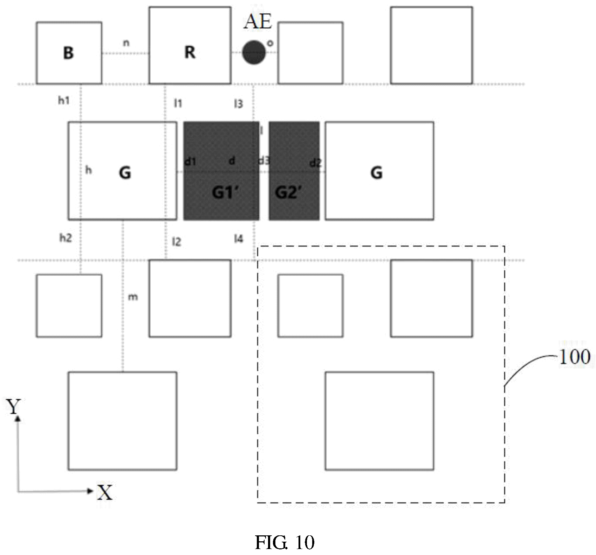

As a third example, FIG. 10 is a top view of a display substrate in the third example according to an embodiment of the present disclosure. As shown in FIG. 10, the third example is substantially the same as the second example. In the third example, two auxiliary sub-pixels G' (i.e., a first auxiliary sub-pixel G1' and a second auxiliary sub-pixel G2') are arranged between two green sub-pixels G adjacent to each other along the row direction X, and the first auxiliary sub-pixel G1' and the second auxiliary sub-pixel G2' are arranged side by side along the row direction X. The third example is different from the second example in that the first and second auxiliary sub-pixels G1' and G2' are different in size. A ratio of the aperture ratio of each of the first auxiliary sub-pixel G1' and the second auxiliary sub-pixel G2' to the aperture ratio of the green sub-pixel G is in a range from 0.1 to 0.6, and the first auxiliary sub-pixel G1' and the second auxiliary sub-pixel G2' have aperture ratios. As show in FIG. 10, an area of the first auxiliary sub-pixel G1' is larger than that of the second auxiliary sub-pixel G2', a ratio of the area of the first auxiliary sub-pixel G1' to the area of the second auxiliary sub-pixel G2' is x2, and x2 satisfies: 3/2≤x2≤5. The positions of the first auxiliary sub-pixel G1' and the second auxiliary sub-pixel G2' may be interchanged.

A distance from the top edge of the first auxiliary sub-pixel G1' to the bottom edge of the red sub-pixel R closest to the top edge of the first auxiliary sub-pixel G1' is l3, and a distance from the top edge of the second auxiliary sub-pixel G2' to the bottom edge of the red sub-pixel R closest to the top edge of the second auxiliary sub-pixel G2' is l3. A distance from the bottom edge of the first auxiliary sub-pixel G1' to the top edge of the red sub-pixel R closest to the bottom edge of the first auxiliary sub-pixel G1' is l4, and a distance from the bottom edge of the second auxiliary sub-pixel G2' to the top edge of the red sub-pixel R closest to the bottom edge of the second auxiliary sub-pixel G2' is l4. For example, 1/6×g1 ≤ l3 and l4≤1/3×g1, wherein l3 and l4 may be equal to or different from each other.

A distance from the first auxiliary sub-pixel G1' to the green sub-pixel G nearest the first auxiliary sub-pixel G1' is d1, and a distance from the second auxiliary sub-pixel G2' to the green sub-pixel G nearest the second auxiliary sub-pixel G2' is d2. d1 and d2 may be equal to or different from each other, wherein 1/10×g1≤d1 and d2≤1/5×g1.

A distance from the first auxiliary sub-pixel G1' to the second auxiliary sub-pixel G2' is d3, wherein 1/10×g1≤d3≤1/6×g1.

In some examples, a ratio of the aperture ratio of the first auxiliary sub-pixel G1' to the aperture ratio of the second auxiliary sub-pixel G2' ranges from about 1.5 to 4. At this time, the auxiliary sub-pixels may be selected to be lighted up according to the requirement, so that the power consumption can be reduced.

In some examples, the quantum dots in the materials for the auxiliary quantum dot unit 402' and the green quantum dot unit 402 are different from each other. It should be noted that in the embodiments of the present disclosure, the materials of the quantum dot unit are considered to be different if only one of the followings is satisfied: the types of quantum dots in the materials of the quantum dot units are different from each other; the types of quantum dots in the materials of the quantum dot units are the same, and the distribution densities of the quantum dots are different from each other; and the quantum dots in the materials of the quantum dot units are the same in type and different in particle size and the like.

In this example, the first auxiliary sub-pixel G1' includes a first auxiliary quantum dot unit located on a light outgoing side of the light-emitting device, and the second auxiliary sub-pixel G2' includes a second auxiliary quantum dot unit located on a light outgoing side of the light-emitting device. The quantum dot materials in the first auxiliary quantum dot unit and the second auxiliary quantum dot unit may include Cd or perovskite (Pb) system materials. The quantum dot materials in the first auxiliary quantum dot unit and the second auxiliary quantum dot unit may be the same as or different from each other. The quantum dot materials in the red quantum dot unit and the green quantum dot unit may include InP, so that the color gamut and the efficiency of the light-emitting device can be improved.

The aperture ratio of the first auxiliary sub-pixel G1' is set to be in a range from 6% to 8%, the aperture ratio of the first auxiliary sub-pixel G1' is set to be in a range from 2% to 4%. In order to meet the requirement of RoHS on heavy metals, when the materials (i.e., the quantum dot ink) of the first auxiliary quantum dot unit and the second auxiliary quantum dot unit includes Cd quantum dots, the content of the Cd quantum dots may be set as follows: 800ppm ≤ x ≤ 1250ppm. When the materials (i.e., the quantum dot ink) of the first auxiliary quantum dot unit and the second auxiliary quantum dot unit include perovskite, the content of Pb in the perovskite quantum dot may be set as follows: 8000ppm ≤ x ≤ 12500ppm, and the remaining part may be filled with InP material, and the concentration (i.e., solid content) of the InP material ranges from 20% to 40%.

Other structures in the example are the same as those in the above example, therefore the description thereof is omitted.

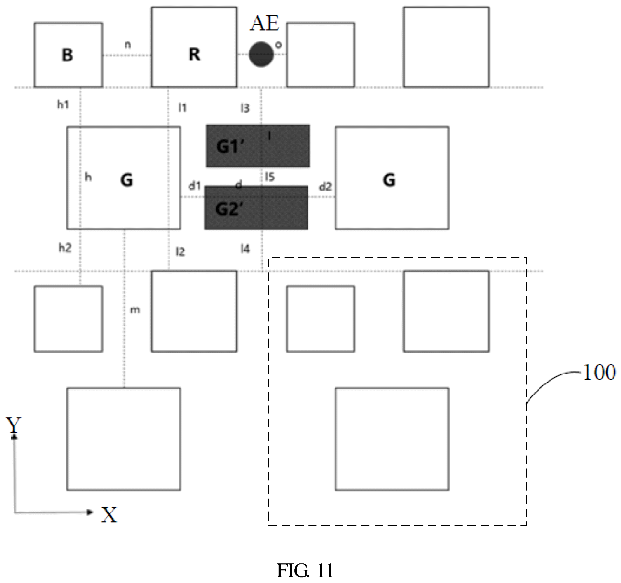

As a fourth example, FIG. 11 is a top view of a display substrate in the fourth example according to an embodiment of the present disclosure. As shown in FIG. 11, the example is substantially the same as the first example. In the example, two auxiliary sub-pixels G', (i.e., a first auxiliary sub-pixel G1' and a second auxiliary sub-pixel G2') are provided between two green sub-pixels G adjacent to each other along the row direction X, and the first auxiliary sub-pixel G1' and the second auxiliary sub-pixel G2' are arranged side by side along the column direction Y. The first auxiliary sub-pixel G1' and the second auxiliary sub-pixel G2' have the same size, and a ratio of the aperture ratio of each of the first auxiliary sub-pixel G1' and the second auxiliary sub-pixel G2' to the aperture ratio of the green sub-pixel G ranges from 0.1 to 0.4.

In some examples, a distance from the top edge of the first auxiliary sub-pixel G1' to the bottom edge of the red sub-pixel R closest to the top edge of the first auxiliary sub-pixel G1' is l3, and a distance from the bottom edge of the second auxiliary sub-pixel G2' to the top edge of the red sub-pixel R closest to the bottom edge of the second auxiliary sub-pixel is l4. For example, 1/6×g1 ≤ l3 and l4≤1/3×g1, wherein l3 and l4 may be equal to or different from each other.

A distance from the first auxiliary sub-pixel G1' to the second auxiliary sub-pixel G2' is l5, and 1/10×g1≤l5≤1/6×g1.

Since the first auxiliary sub-pixel G1' and the second auxiliary sub-pixel G2' have the same length along the row direction X, distances from the first auxiliary sub-pixel G1' and the second auxiliary sub-pixel G2' respectively to the two green sub-pixels G located on both sides of the first auxiliary sub-pixel G1' and the second auxiliary sub-pixel G2' are d1 and d2, d1 and d2 may be equal to or different from each other, where 1/10×g1≤d1, and d2≤1/5×g1.

In some examples, the aperture ratios of the first auxiliary sub-pixel G1' and the second auxiliary sub-pixel G2' may be different from each other, for example, a ratio of the aperture ratio of the first auxiliary sub-pixel G1' to the aperture ratio of the second auxiliary sub-pixel G2' ranges from about 1.5 to 4. At this time, the auxiliary sub-pixel(s) G' may be selected to be lighted up according to the requirement, so that the power consumption can be reduced.

In some examples, the quantum dots in the material of the auxiliary quantum dot unit 402' and the quantum dots in the material of the green quantum dot unit 402 are different from each other. It should be noted that in the embodiments of the present disclosure, the materials of the quantum dot units are considered to be different from each other if one of the followings is satisfied: quantum dots in the materials of the quantum dot units have different types; the quantum dots in the materials of the quantum dot units are the same in type, and the distribution densities of the quantum dots are different from each other; and the quantum dots in the material of the quantum dot unit are the same in type and different in particle size and the like.

In the example, the first auxiliary sub-pixel G1' includes a first auxiliary quantum dot unit located on a light outgoing side of the light-emitting device, and the second auxiliary sub-pixel G2' includes a second auxiliary quantum dot unit located on a light outgoing side of the light-emitting device. The quantum dot materials in the first auxiliary quantum dot unit and the second auxiliary quantum dot unit may include Cd or perovskite (Pb) system materials. The quantum dot materials in the first auxiliary quantum dot unit and the second auxiliary quantum dot unit may be the same as or different from each other. The quantum dot materials in the red quantum dot unit and the green quantum dot unit may include InP, so as to improve the color gamut and efficiency of the light-emitting device.

The aperture ratios of the first and second auxiliary sub-pixels G1' and G2' are set to be in a range from 2% to 5%, the aperture ratios of the first and second auxiliary sub-pixels G1' are the same. In order to meet the requirement of RoHS on heavy metals, when the materials (i.e., the quantum dot ink) of the first auxiliary quantum dot unit and the second auxiliary quantum dot unit include Cd quantum dots, the content of the Cd quantum dots may be set as follows: 1000ppm ≤ x ≤ 2000ppm. When the materials (i.e., the quantum dot ink) of the first auxiliary quantum dot unit and the second auxiliary quantum dot unit include perovskite, the content of Pb in the perovskite quantum dot may be set as follows: 10000ppm ≤ x ≤ 20000ppm, and the remaining part may be filled with InP material, and the concentration (i.e., solid content) of the InP material may be set to be in a range from 20% to 40%.

The remaining structures in the example are the same as the above example, and therefore, the description thereof is omitted.

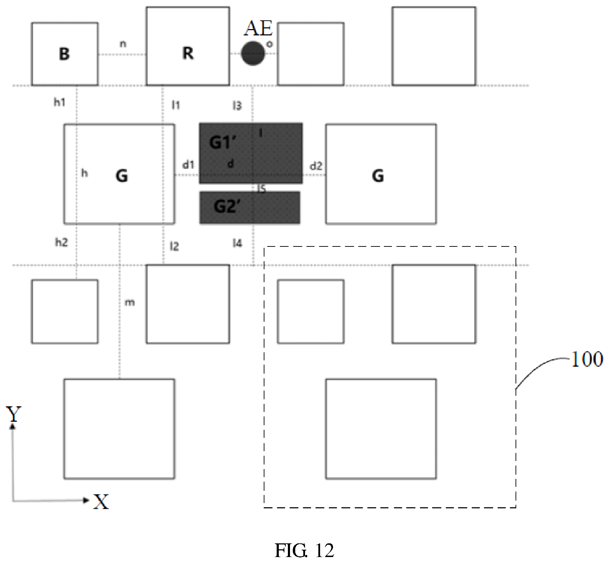

As a fifth example, FIG. 12 is a top view of a display substrate in the fifth example according to an embodiment of the present disclosure. As shown in FIG. 12, the example is substantially the same as the fourth example. In the example, two auxiliary sub-pixels G' (i.e., a first auxiliary sub-pixel G1' and a second auxiliary sub-pixel G2') are arranged between two green sub-pixels G adjacent to each other along the row direction X, and the first auxiliary sub-pixel G1' and the second auxiliary sub-pixel G2' are arranged side by side along the column direction Y. The example is different from the fourth example in that the first and second auxiliary sub-pixels G1' and G2' are different in size. A ratio of the aperture ratio of each of the first auxiliary sub-pixel G1' and the second auxiliary sub-pixel G2' to the aperture ratio of the green sub-pixel G ranges from 0.1 to 0.6, but the aperture ratios of the first auxiliary sub-pixel G1' and the second auxiliary sub-pixel G2' are different from each other. As shown in FIG. 12, an area of the first auxiliary sub-pixel G1' is larger than that of the second auxiliary sub-pixel G2', a ratio of the area of the first auxiliary sub-pixel G1' to the area of the second auxiliary sub-pixel G2' is x3, and x3 satisfies: 3/2≤x2≤5. The positions of the first auxiliary sub-pixel G1' and the second auxiliary sub-pixel G2' may be interchanged. a ratio of the aperture ratio of each of the first auxiliary sub-pixel G1' and the second auxiliary sub-pixel G2' to the aperture ratio of the green sub-pixel G ranges from 0.1 to 0.6, but the aperture ratios of the two are not the same, as shown in FIG. 12, the area of the first auxiliary sub-pixel G1'is larger than that of the second auxiliary sub-pixel G2', a ratio of the area of the first auxiliary sub-pixel G1' to the area of the second auxiliary sub-pixel G2' is x2, and x2 satisfies: 3/2 ≤ x2 ≤ 5. The positions of the first auxiliary sub-pixel G1' and the second auxiliary sub-pixel G2' may be interchanged left and right.

In some examples, a distance from the top edge of the first auxiliary sub-pixel G1' and the bottom edge of the red sub-pixel R closest to the top edge of the first auxiliary sub-pixel G1' is l3, and a distance from the bottom edge of the second auxiliary sub-pixel G2' and the top edge of the red sub-pixel R closest to the bottom edge of the second auxiliary sub-pixel G2' is l4. For example, 1/6×g1 ≤13, 14≤1/3×g1, wherein l3 and l4 may be equal to or different from each other.

A distance from the first auxiliary sub-pixel G1' to the second auxiliary sub-pixel G2' is l5, and 1/10×g1≤l5≤1/6×g1.

Since the first auxiliary sub-pixel G1' and the second auxiliary sub-pixel G2' have the same length along the row direction X, distances from the first auxiliary sub-pixel G1' and the second auxiliary sub-pixel G2' respectively to the two green sub-pixels G located on both sides of the first auxiliary sub-pixel G1' and the second auxiliary sub-pixel G2' are d1 and d2, d1 and d2 may be equal to or different from each other, wherein 1/10×g1≤d1 and d2≤1/5×g1.

In some examples, a ratio of the aperture ratio of the first auxiliary sub-pixel G1' to the aperture ratio of the second auxiliary sub-pixel G2' ranges from about 1.5 to 4. At this time, one of the auxiliary sub-pixels may be selected to be lighted up according to the requirement, so that the power consumption can be reduced.

In some examples, the quantum dots in the material of the auxiliary quantum dot unit 402' and the quantum dots in the material of the green quantum dot unit 402 are different from each other. It should be noted that in the embodiments of the present disclosure, the materials of the quantum dot units are considered to be different from each other if one of the followings is satisfied: quantum dots in the materials of the quantum dot units have different types; the quantum dots in the materials of the quantum dot units are the same in type, and the distribution densities of the quantum dots are different from each other; and the quantum dots in the material of the quantum dot unit are the same in type and different in particle size and the like.

In the example, the first auxiliary sub-pixel G1' includes a first auxiliary quantum dot unit located on a light outgoing side of the light-emitting device, and the second auxiliary sub-pixel G2' includes a second auxiliary quantum dot unit located on a light outgoing side of the light-emitting device. The quantum dot materials in the first auxiliary quantum dot unit and the second auxiliary quantum dot unit may include Cd or perovskite (Pb) system materials. The quantum dot materials in the first auxiliary quantum dot unit and the second auxiliary quantum dot unit may be the same as or different from each other. The quantum dot materials in the red quantum dot unit and the green quantum dot unit may include InP, so as to improve the color gamut and efficiency of the light-emitting device.

The aperture ratio of the first auxiliary sub-pixel G1' is set to be in a range from 6% to 8%, and the aperture ratio of the first auxiliary sub-pixel G1' is set to be in a range from 2% to 4%.In order to meet the requirement of RoHS on heavy metals, when the materials (i.e., the quantum dot ink) of the first auxiliary quantum dot unit and the second auxiliary quantum dot unit include Cd quantum dots, the content of the Cd quantum dots may be set as follows: 800ppm ≤ x ≤ 1250ppm. When the materials (i.e., the quantum dot ink) of the first auxiliary quantum dot unit and the second auxiliary quantum dot unit include perovskite, the content of Pb in the perovskite quantum dot may be set as follows: 8000ppm ≤ x ≤ 12500ppm, and the remaining part may be filled with InP material, and the concentration (i.e., solid content) of the InP material may be set to be in a range from 20% to 40%.

The remaining structures in the example are the same as the above example, and therefore, the description thereof is omitted.

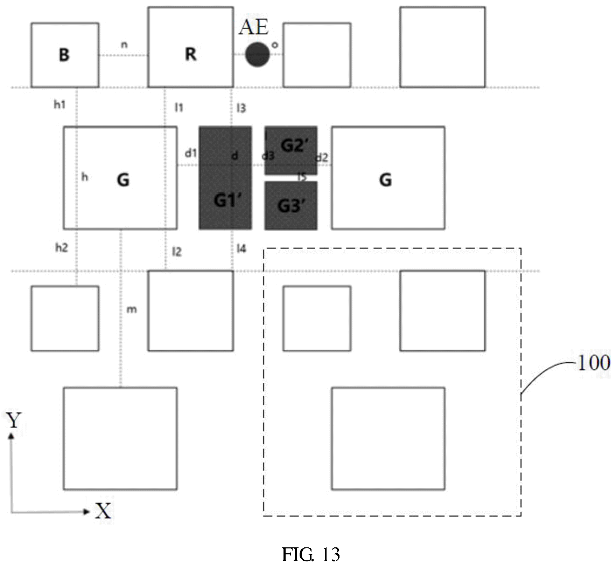

As a sixth example, FIG. 13 is a top view of a display substrate in the sixth example according to an embodiment of the present disclosure. As shown in FIG. 13, in the example, three auxiliary sub-pixels G' (i.e., a first auxiliary sub-pixel G1', a second auxiliary sub-pixel G2', and a third auxiliary sub-pixel G3') are arranged between two green sub-pixels G adjacent to each other along the row direction X. The second auxiliary sub-pixel G2' and the third auxiliary sub-pixel G3' are arranged side by side along the column direction Y, and the first auxiliary sub-pixel G1' and a combination of the second auxiliary sub-pixel G2' and the third auxiliary sub-pixel G3' are arranged side by side along the row direction X. The positions of the first auxiliary sub-pixel G1' and the combination of the second and third auxiliary sub-pixels G2' and G3' may be interchanged. A ratio of the aperture ratio of the first auxiliary sub-pixel G1' to the aperture ratio of the green sub-pixel G ranges from 0.1 to 0.4. A ratio of the aperture ratio of the second auxiliary sub-pixel G2' to the aperture ratio of the green sub-pixel G is the same as a ratio of the aperture ratio of the third auxiliary sub-pixel G3' to the aperture ratio of the green sub-pixel G, with both ranging from 0.1 to 0.4.

In some examples, a distance from the top edge of the first auxiliary sub-pixel G1' and the bottom edge of the red sub-pixel R closest to the top edge of the first auxiliary sub-pixel G1' is l3, and a distance between the top edge of the second auxiliary sub-pixel G2' to the bottom edge of the red sub-pixel R closest to the top edge of the second auxiliary sub-pixel G2' is l3. A distance from the bottom edge of the first auxiliary sub-pixel G1' to the top edge of the red sub-pixel R closest to the bottom edge of the first auxiliary sub-pixel G1' is l4, and a distance from the bottom edge of the third auxiliary sub-pixel G3' to the top edge of the red sub-pixel R closest to the bottom edge of the third auxiliary sub-pixel G3' is l4. For example, 1/6×g1 ≤ 13, and l4≤1/3×g1, wherein l3 and l4 may be equal to or different from each other.

A distance from the first auxiliary sub-pixel G1' to the green sub-pixel G nearest the first auxiliary sub-pixel G1' is d1, and a distance from the second auxiliary sub-pixel G2' and the third auxiliary sub-pixel G3' respectively to the green sub-pixel G nearest the second auxiliary sub-pixel G2' and the third auxiliary sub-pixel G3' to is d2, and d1 and d2 may be equal to or different frome each other, 1/10×g1≤d1, and d2≤1/5×g1.

A distance from the first auxiliary sub-pixel G1' to the second auxiliary sub-pixel G2' is d3, and a distance from the first auxiliary sub-pixel G1' to the third auxiliary sub-pixel G3' is d3, 1/10×g1≤d3≤1/6×g1.

In some examples, a ratio of the aperture ratio of the first auxiliary sub-pixel G1' to the aperture ratio of the second auxiliary sub-pixel G2' ranges from about 1.5 to 4. At this time, one of the auxiliary sub-pixels may be selected to be lighted up according to the requirement, so that the power consumption can be reduced.

In some examples, the quantum dots in the material of the auxiliary quantum dot unit 402' and the quantum dots in the material of the green quantum dot unit 402 are different from each other. It should be noted that in the embodiments of the present disclosure, the materials of the quantum dot units are considered to be different from each other if one of the followings is satisfied: quantum dots in the materials of the quantum dot units have different types; the quantum dots in the materials of the quantum dot units are the same in type, and the distribution densities of the quantum dots are different from each other; and the quantum dots in the material of the quantum dot unit are the same in type and different in particle size and the like.

In the example, the first auxiliary sub-pixel G1' includes a first auxiliary quantum dot unit located on a light outgoing side of the light-emitting device, the second auxiliary sub-pixel G2' includes a second auxiliary quantum dot unit located on a light outgoing side of the light-emitting device, and the third auxiliary sub-pixel G3' includes a second auxiliary quantum dot unit located on a light outgoing side of the light-emitting device. The quantum dot materials in the first, second, and third auxiliary quantum dot units may include Cd or perovskite (Pb) system materials. The quantum dot materials in the first, second, and third auxiliary quantum dot units may be the same as or different from each other. The quantum dot materials in the red quantum dot unit and the green quantum dot unit may include InP, so as to improve the color gamut and efficiency of the light-emitting device.

The aperture ratio of the first auxiliary sub-pixel G1' is set to be in a range from 2% to 5%, and the aperture ratio of each of the second and third auxiliary sub-pixels G1' are set to be in a range from 1% to 4%, the two aperture ratios may be equal to or different from each other. In order to meet the requirement of RoHS on heavy metals, when the materials (i.e., the quantum dot ink) of the first, second and third auxiliary quantum dot units include Cd quantum dots, the content of the Cd quantum dots may be set as follows: 750ppm ≤ x ≤ 2500ppm. When the materials (i.e., the quantum dot ink) of the first, second and third auxiliary quantum dot units include perovskite, the content of Pb in the perovskite quantum dot may be set as follows: 7500ppm≤x≤25000ppm, and the remaining part may be filled with InP material, and the concentration (solid content) of the InP material may be set to be in a range from 20% to 40%.

The rest of the structure in this example is the same as the above example, and therefore, the description thereof is omitted.

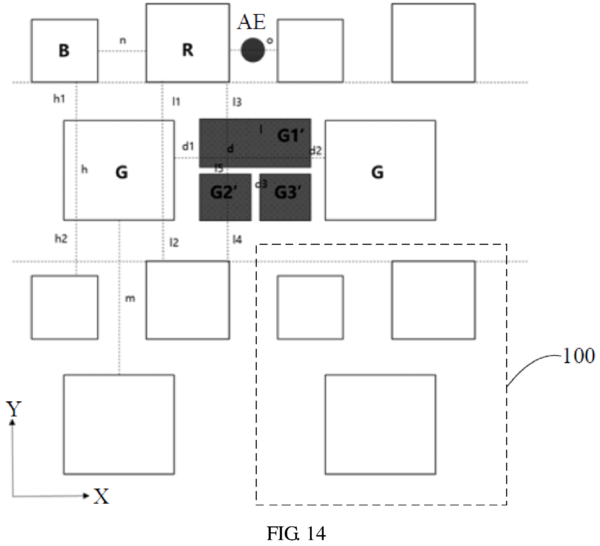

As a seventh example, FIG. 14 is a top view of a display substrate in the seventh example according to an embodiment of the present disclosure. As shown in FIG. 14, in the example, three auxiliary sub-pixels G' (i.e., a first auxiliary sub-pixel G1', a second auxiliary sub-pixel G2', and a third auxiliary sub-pixel G3') are arranged between two green sub-pixels G adjacent to each other along the row direction X, respectively. The second auxiliary sub-pixel G2' and the third auxiliary sub-pixel G3' are arranged side by side along the row direction X, and the first auxiliary sub-pixel G1' and a combination of the second auxiliary sub-pixel G2' and the third auxiliary sub-pixel G3' are arranged side by side along the column direction Y. The positions of the first auxiliary sub-pixel G1' and the combination of the second and third auxiliary sub-pixels G2' and G3' may be interchanged. A ratio of the aperture ratio of the first auxiliary sub-pixel G1' to the aperture ratio of the green sub-pixel G ranges from 0.1 to 0.4. A ratio of the aperture ratio of the second auxiliary sub-pixel G2' to the aperture ratio of the green sub-pixel G may be the same as a ratio of the aperture ratio of and the third auxiliary sub-pixel G3' to the aperture ratio of the green sub-pixel G, with both ranging from 0.1 to 0.4.

In some examples, a distance from the top edge of the first auxiliary sub-pixel G1' and the bottom edge of the red sub-pixel R closest to the top edge of the first auxiliary sub-pixel G1' is l3, a distance between the bottom edge of the second auxiliary sub-pixel G2' to the top edge of the red sub-pixel R closest to the bottom edge of the second auxiliary sub-pixel G2' is l4, and a distance between the bottom edge of the third auxiliary sub-pixel G3' to the top edge of the red sub-pixel R closest to the bottom edge of the third auxiliary sub-pixel G3' is l4. For example, 1/6×g1 ≤ l3 and l4≤1/3×g1, wherein l3 and l4 may be equal to or different from each other.

A distance from the first auxiliary sub-pixel G1' to the second auxiliary sub-pixel G2' is l5, and a distance from the first auxiliary sub-pixel G1' to the third auxiliary sub-pixel G3' is l5, 1/10×g1≤l5≤1/6×g1.

The distances from the first auxiliary sub-pixel G1' respectively to the two green sub-pixels G closest to the first auxiliary sub-pixel G1'are d1 and d2, a distance from the second auxiliary sub-pixel G2' to the green sub-pixel G closest to the second auxiliary sub-pixel G2' is d1, a distance from the third auxiliary sub-pixel G3' to the green sub-pixel G closest to the third auxiliary sub-pixel G3'are d2. d1 and d2 may be equal to or different from each other, and 1/10×g1≤d1 and d2≤1/5×g1.

In some examples, a ratio of the aperture ratio of the first auxiliary sub-pixel G1' to the aperture ratio of the second auxiliary sub-pixel G2' is in a range from about 1.5 to 4. At this time, the auxiliary sub-pixel(s) G' may be selected to be lighted up according to the requirement, so that the power consumption can be reduced.

In some examples, the quantum dots in the material of the auxiliary quantum dot unit 402' and the quantum dots in the material of the green quantum dot unit 402 are different from each other. It should be noted that in the embodiments of the present disclosure, the materials of the quantum dot units are considered to be different from each other if one of the followings is satisfied: quantum dots in the materials of the quantum dot units have different types; the quantum dots in the materials of the quantum dot units are the same in type, and the distribution densities of the quantum dots are different from each other; and the quantum dots in the material of the quantum dot unit are the same in type and different in particle size and the like.

In the example, the first auxiliary sub-pixel G1' includes a first auxiliary quantum dot unit located on a light outgoing side of the light-emitting device, the second auxiliary sub-pixel G2' includes a second auxiliary quantum dot unit located on a light outgoing side of the light-emitting device, and the third auxiliary sub-pixel G3' includes a second auxiliary quantum dot unit located on a light outgoing side of the light-emitting device. The quantum dot materials in the first, second, and third auxiliary quantum dot units may include Cd or perovskite (Pb) system materials. The quantum dot materials in the first, second, and third auxiliary quantum dot units may be the same as or different from each other. The quantum dot materials in the red quantum dot unit and the green quantum dot unit may include InP, so as to improve the color gamut and efficiency of the light-emitting device.

The aperture ratio of the first auxiliary sub-pixel G1' is set to be in a range from 2% to 5%, and the aperture ratio of each of the second and third auxiliary sub-pixels G1' are set to be in a range from 1% to 4%, the two aperture ratios may be different from or the same as each other. In order to meet the requirement of RoHS on heavy metals, when the materials (i.e., the quantum dot ink) of the first, second and third auxiliary quantum dot units include Cd quantum dots, the content of the Cd quantum dots may be set as follows: 750ppm≤x≤2500ppm. When the materials (i.e., the quantum dot ink) of the first, second and third auxiliary quantum dot units include perovskite, the content of Pb in the perovskite quantum dot may be set as follows: 7500ppm≤x≤25000ppm, and the remaining part may be filled with InP material, and the concentration (solid content) of the InP material may be set to be in a range from 20% to 40%.

The rest of the structure in this example is the same as the above example, and therefore, the description thereof is omitted.

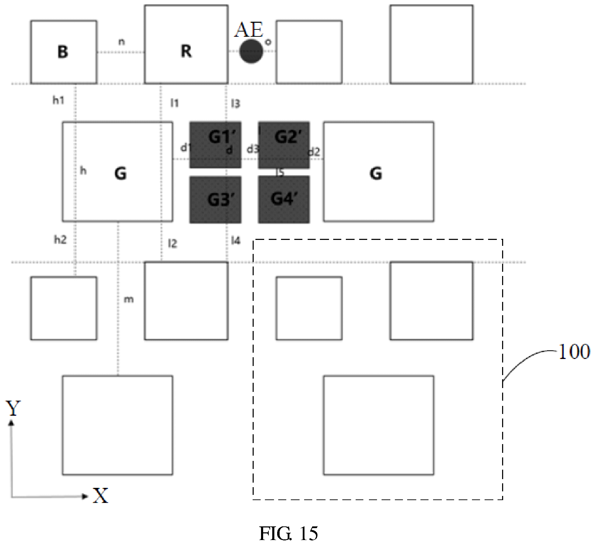

As an eighth example, FIG. 15 is a top view of a display substrate in the eighth example according to an embodiment of the present disclosure. As shown in FIG. 15, in the example, four auxiliary sub-pixels G' (i.e., a first auxiliary sub-pixel G1', a second auxiliary sub-pixel G2', a third auxiliary sub-pixel G3', and a fourth auxiliary sub-pixel G4') arranged in an array are arranged between two adjacent green sub-pixels G along the row direction X. A ratio of the aperture ratio of each of the first auxiliary sub-pixel G1', the second auxiliary sub-pixel G2', the third auxiliary sub-pixel G3', and the fourth auxiliary sub-pixel G4' to the aperture ratio of the green sub-pixel G may be the same and in a range from 0.05 to 0.2. The first auxiliary sub-pixel G1', the second auxiliary sub-pixel G2', the third auxiliary sub-pixel G3', and the fourth auxiliary sub-pixel G4' have the same aperture size as that of the green sub-pixel G.

In some examples, a distance from the top edge of the first auxiliary sub-pixel G1' and the bottom edge of the red sub-pixel R closest to the top edge of the first auxiliary sub-pixel G1' is l3, a distance from the top edge of the second auxiliary sub-pixel G2' to the bottom edge of the red sub-pixel R closest to the top edge of the second auxiliary sub-pixel G2' is l3, a distance from the bottom edge of the third auxiliary sub-pixel G3' to the top edge of the red sub-pixel R closest to the bottom edge of the third auxiliary sub-pixel G3' is l4, and a distance from the bottom edge of the fourth auxiliary sub-pixel G4' to the top edge of the red sub-pixel R closest to the bottom edge of the fourth auxiliary sub-pixel G4' is l4. For example, 1/6×g1 ≤ 13 and 14 ≤ 1/3×g1, wherein l3 and l4 may be equal to or different from each other.

A distance from the first auxiliary sub-pixel G1' and the green sub-pixel G nearest the first auxiliary sub-pixel G1' is d1, a distance from the second auxiliary sub-pixel G2' and the green sub-pixel G nearest the second auxiliary sub-pixel G2' is d2, a distance between the third auxiliary sub-pixel G3' and the green sub-pixel G nearest the third auxiliary sub-pixel G3' is d1, and a distance from the fourth auxiliary sub-pixel G4' to the green sub-pixel G nearest the fourth auxiliary sub-pixel G4' is d2, where d1 and d2 may be equal to or different from each other, 1/10×g1≤d1 and d2≤1/5×g1.

A distance from the first auxiliary sub-pixel G1' to the second auxiliary sub-pixel G2' is d3, and a distance from the third auxiliary sub-pixel G3' to the fourth auxiliary sub-pixel G4' is d3, 1/10×g1≤d3≤1/6×g1.

A distance from the first auxiliary sub-pixel G1' to the third auxiliary sub-pixel G3' is l5, and a distance from the second auxiliary sub-pixel G2' to the fourth auxiliary sub-pixel G4' is l5, 1/10×g1≤l5≤1/6×g1.

In some examples, at least two of the first, second, third and fourth auxiliary sub-pixels G1', G2', G3' and G4' have different aperture ratios, wherein the ratio of the largest aperture ratio to the smallest aperture ratio ranges from about 1.5 to 4. At this time, the auxiliary sub-pixel(s) G' may be selected to be lighted up according to the requirement, so that the power consumption can be reduced.

In some examples, the quantum dots in the material of the auxiliary quantum dot unit 402' and the quantum dots in the material of the green quantum dot unit 402 are different from each other. It should be noted that in the embodiments of the present disclosure, the materials of the quantum dot units are considered to be different from each other if one of the followings is satisfied: quantum dots in the materials of the quantum dot units have different types; the quantum dots in the materials of the quantum dot units are the same in type, and the distribution densities of the quantum dots are different from each other; and the quantum dots in the material of the quantum dot unit are the same in type and different in particle size and the like.

In the example, the first auxiliary sub-pixel G1' includes a first auxiliary quantum dot unit located on a light outgoing side of the light-emitting device, the second auxiliary sub-pixel G2' includes a second auxiliary quantum dot unit located on a light outgoing side of the light-emitting device, the third auxiliary sub-pixel G3' includes a second auxiliary quantum dot unit located on a light outgoing side of the light-emitting device, and the fourth auxiliary sub-pixel G4' includes a second auxiliary quantum dot unit located on a light outgoing side of the light-emitting device. The quantum dot materials in the first, second, third and fourth auxiliary quantum dot units may include Cd or perovskite (Pb) system materials. The quantum dot materials in the first, second, third and fourth auxiliary quantum dot units may be the same as or different from each other. The quantum dot materials in the red quantum dot unit and the green quantum dot unit may include InP, so as to improve the color gamut and efficiency of the light-emitting device.

The aperture ratios of the first, second, third and fourth auxiliary sub-pixels G1', G2', G3' and G4' are set to be in a range from 1% to 4%, and the four aperture ratios may be different from or the same as each other. In order to meet the requirement of RoHS on heavy metals, when the materials (i.e., the quantum dot ink) of the first, second, third and fourth auxiliary quantum dot units include Cd quantum dots, the content of the Cd quantum dots may be set as follows: 600ppm≤x≤2500ppm. When the materials (i.e., the quantum dot ink) of the first, second, third, and fourth auxiliary quantum dot units include perovskite, the content of Pb in the perovskite quantum dot may be set as follows: 6000ppm ≤ x ≤ 25000ppm, and the remaining part may be filled with InP material, and the concentration (solid content) of the InP material may be set to be in a range from 20% to 40%.

The rest of the structure in this example is the same as the above example, and therefore, the description thereof is omitted.

An embodiment of the present disclosure further provides a display device, which includes the display substrate in any one of above examples.

It will be understood that the above embodiments are merely exemplary embodiments adopted to illustrate the principles of the present disclosure, and the present disclosure is not limited thereto. It will be apparent to those skilled in the art that various modifications and improvements can be made without departing from the spirit and essence of the present disclosure, and such modifications and improvements are also considered to be within the scope of the present disclosure.

## Claims

1. A display substrate, comprising:
a base substrate; and
pixel units arranged in an array on the base substrate, wherein each of the pixel units comprises a first sub-pixel, a second sub-pixel and a third sub-pixel respectively emitting light in different colors, and the first sub-pixel is in the same row as the third sub-pixel and in a different row from the second sub-pixel, wherein
the display substrate comprises at least one auxiliary sub-pixel between the second sub-pixels of the pixel units in the same row, wherein the at least one auxiliary sub-pixel emits light in the same color as the second sub-pixel.

2. The display substrate of claim 1, further comprising a driving circuit layer on a side of a layer on which a light-emitting device is located close to the base substrate, wherein
the driving circuit layer comprises a first power signal line electrically coupled to a second electrode of the light-emitting device through an auxiliary electrode, and
an orthographic projection of the auxiliary electrode on the base substrate is between an orthographic projection of a light-emitting device for the first sub-pixel on the base substrate and an orthographic projection of a light-emitting device for the third sub-pixel on the base substrate, with the first sub-pixel being adjacent to the third sub-pixel along a row direction .

3. The display substrate of claim 2, further comprising:
a first interlayer insulating layer between the driving circuit layer and a layer on which a first electrode of a light-emitting device is located, and
a pixel definition layer on a side of the first electrode of the light-emitting device away from the base substrate, wherein
the auxiliary electrode is in the same layer as the first electrode of the light-emitting device and is coupled to the first power signal line through a first through-hole penetrating through the first interlayer insulating layer; and
the pixel definition layer has a first through-hole at a position of the auxiliary electrode and penetrating through the pixel definition layer along a thickness direction of the pixel definition layer, and a side wall of the first through-hole is covered with a protective layer.

4. The display substrate of claim 2, further comprising an electron conduction layer on a surface of the auxiliary electrode away from the base substrate.

5. The display substrate of claim 4, wherein the first sub-pixel and the third sub-pixel belong to two different ones of the pixel units, with orthographic projections of the first sub-pixel and the third sub-pixel on the base substrate being respectively on both sides of an orthographic projection of the auxiliary electrode on the base substrate.

6. The display substrate of claim 1, further comprising:
a pixel definition layer on a side of a first electrode of a light-emitting device away from the base substrate, the pixel definition layer having a first accommodating portion, a second accommodating portion, a third accommodating portion, and an auxiliary accommodating portion respectively penetrating through the pixel definition layer along a thickness direction of the pixel definition layer,
wherein a light-emitting layer of the light-emitting device for the first sub-pixel covers the first accommodating portion, a light-emitting layer of the light-emitting device for the second sub-pixel covers the second accommodating portion, a light-emitting layer of the light-emitting device for the third sub-pixel covers the third accommodating portion, and a light-emitting layer of the light-emitting device for the auxiliary sub-pixel covers the auxiliary accommodating portion,
the second accommodating portion has a length of g1 along a row direction,
a minimum distance from the first accommodating portion of the pixel unit in an i^{th} row and a j^{th} column to the auxiliary accommodating portion between the second accommodating portion of the pixel unit in the i^{th} row and the j^{th} column and the second accommodating portion of the pixel unit in the i^{th} row and a (j+1)^{th} column is l3, and
a minimum distance from the first accommodating portion of the pixel unit in an (i+1)^{th} row and the j^{th} column to the auxiliary accommodating portion between the second accommodating portion of the pixel unit in the i^{th} row and the j^{th} column and the second accommodating portion of the pixel unit in the i^{th} row and the (j+1)^{th} column is l4, with i and j being positive integers, l3≥1/6×g1 and l4≤1/3×g1.

7. The display substrate of claim 1, further comprising:
a pixel definition layer on a side of a first electrode of a light-emitting device away from the base substrate, the pixel definition layer having a first accommodating portion, a second accommodating portion, a third accommodating portion, and an auxiliary accommodating portion respectively penetrating through the pixel definition layer along a thickness direction of the pixel definition layer,
wherein a light-emitting layer of the light-emitting device for the first sub-pixel covers the first accommodating portion, a light-emitting layer of the light-emitting device for the second sub-pixel covers the second accommodating portion, a light-emitting layer of the light-emitting device for the third sub-pixel covers the third accommodating portion, and a light-emitting layer of the light-emitting device for the auxiliary sub-pixel covers the auxiliary accommodating portion,
the second accommodating portion has a length of g1 along a row direction, and
a plurality of auxiliary accommodating portions are arranged between the adjacent second accommodating portions, at least part of the plurality of auxiliary accommodating portions are arranged side by side along a column direction, and an interval between the auxiliary accommodating portions side by side along the column direction is l5, 1/10×g1≤l5≤1/6×g1.

8. The display substrate of claim 1, further comprising:
a pixel definition layer on a side of a first electrode of a light-emitting device away from the base substrate, the pixel definition layer having a first accommodating portion, a second accommodating portion, a third accommodating portion, and an auxiliary accommodating portion respectively penetrating through the pixel definition layer along a thickness direction of the pixel definition layer,
wherein a light-emitting layer of the light-emitting device for the first sub-pixel covers the first accommodating portion, a light-emitting layer of the light-emitting device for the second sub-pixel covers the second accommodating portion, a light-emitting layer of the light-emitting device for the third sub-pixel covers the third accommodating portion, and a light-emitting layer of the light-emitting device for the auxiliary sub-pixel covers the auxiliary accommodating portion,
the second accommodating portion has a length of g1 along a row direction, and
for two second accommodating portions adjacent to each other along the row direction and the auxiliary accommodating portions between the two second accommodating portions, a minimum distance from one of the two second accommodating portions to the auxiliary accommodating portions is d1, and a minimum distance from the other of the two second accommodating portions to the auxiliary accommodating portions is d2, d1≥1/10×g1 and d2≤1/5×g1.

9. The display substrate of claim 1, further comprising:
a pixel definition layer on a side of a first electrode of a light-emitting device away from the base substrate, the pixel definition layer having a first accommodating portion, a second accommodating portion, a third accommodating portion, and an auxiliary accommodating portion respectively penetrating through the pixel definition layer along a thickness direction of the pixel definition layer,
wherein a light-emitting layer of the light-emitting device for the first sub-pixel covers the first accommodating portion, a light-emitting layer of the light-emitting device for the second sub-pixel covers the second accommodating portion, a light-emitting layer of the light-emitting device for the third sub-pixel covers the third accommodating portion, and a light-emitting layer of the light-emitting device for the auxiliary sub-pixel covers the auxiliary accommodating portion,
the second accommodating portion has a length of g1 along a row direction, and
a plurality of the auxiliary accommodating portions are between the adjacent second accommodating portions, at least part of the plurality of auxiliary accommodating portions are arranged side by side along the row direction, and an interval between the auxiliary accommodating portions side by side along the row direction is d3, 1/10×g1≤d3≤1/6×g1.

10. The display substrate of claim 1, wherein only one auxiliary sub-pixel is disposed between the second sub-pixels adjacent to each other along a row direction, and a ratio of an aperture ratio of the auxiliary sub-pixel to an aperture ratio of each second sub-pixel ranges from 0.5 to 10.

11. The display substrate of claim 1, wherein a plurality of auxiliary sub-pixels are arranged side by side along a row direction between the second sub-pixels adjacent to each other along the row direction, and a ratio of an aperture ratio of each auxiliary sub-pixel to an aperture ratio of each second sub-pixel ranges from 0.1 to 0.6.

12. The display substrate of claim 1, wherein a plurality of the auxiliary sub-pixels are arranged side by side along a column direction between the second sub-pixels adjacent to each other along a row direction, and a ratio of an aperture ratio of each auxiliary sub-pixel to an aperture ratio of each second sub-pixel ranges from 0.1 to 0.6.

13. The display substrate of claim 1, wherein a plurality of auxiliary sub-pixels are disposed between the second sub-pixels adjacent to each other along a row direction, a part of the plurality of auxiliary sub-pixels are arranged side by side along the row direction, the other part of the plurality of auxiliary sub-pixels are arranged side by side along a column direction, and a ratio of an aperture ratio of each auxiliary sub-pixel to an aperture ratio of each second sub-pixel ranges from 0.05 to 0.4.

14. The display substrate of claim 1, wherein a plurality of auxiliary sub-pixels are disposed between the second sub-pixels adjacent to each other along a row direction, and aperture ratios of at least part of the plurality of auxiliary sub-pixels are different from each other.

15. The display substrate of claim 14, wherein for the plurality of auxiliary sub-pixels between the second sub-pixels adjacent to each other along the row direction, a ratio of an aperture ratio of the auxiliary sub-pixel with the largest aperture ratio to an aperture ratio of the auxiliary sub-pixel with the smallest aperture ratio ranges from 1.5 to 4.

16. The display substrate of any one of claims 1 to 15, wherein the first sub-pixel, the second sub-pixel, the third sub-pixel, and the auxiliary sub-pixel each comprise a light-emitting device emitting light in a third color, and
the first sub-pixel further comprises a first quantum dot unit on a light outgoing side of the light-emitting device, the second sub-pixel further comprises a second quantum dot unit on the light outgoing side of the light-emitting device, and the auxiliary sub-pixel further comprises an auxiliary quantum dot unit on the light outgoing side of the light-emitting device, with the first quantum dot unit being configured to emit light in a first color under excitation of light in the third color and the second quantum dot unit and the auxiliary quantum dot unit being both configured to emit light in a second color under excitation of light in the third color.

17. The display substrate of claim 16, wherein a material of the auxiliary quantum dot unit is different from a material of the second quantum dot unit.

18. The display substrate of claim 17, wherein the quantum dots in the materials of the auxiliary quantum dot unit and the second quantum dot unit are the same in type and different in distribution density; and/or the quantum dots in the materials of the auxiliary quantum dot unit and the second quantum dot unit are the same in type and different in particle size.

19. The display substrate of claim 18, wherein a type of quantum dots in the material of the auxiliary quantum dot unit is different from that of quantum dots in the material of the second auxiliary quantum dot unit.

20. A display device, comprising the display substrate of any one of claims 1 to 19.
